# EUROPEAN PATENT APPLICATION

(11) **EP 4 811 078 A1**
(43) Date of publication of application: **23.09.2026**
(21) Application number: 26163688.0
(22) Date of filing: 10.03.2026
(51) Int. Cl.: G06F 1/20

(54) **SYSTEM AND METHOD FOR OPTIMIZATION OF ENERGY CONSUMPTION OF HVAC SYSTEM IN A DATA CENTER**

(30) Priority: 20.03.2025 IN 202541025260
(71) Applicant: ABB Schweiz AG, 5400 Baden (CH)
(72) Inventor: CHIDAMBARAN, Sharat, 560076 Bengaluru (IN); CHATTERJEE, Somenath, 700051 Kolkata (IN); BHATTACHARYA, Aninda, 560100 Bangalore (IN); CHATTERJEE, Anindya, 560048 Bengaluru (IN); RAMACHANDRAN, Rajesh, 560076 Bangalore (IN); BALACHANDRAN, Aravind, 683574 Kalady (IN)
(74) Representative: Zimmermann & Partner Patentanwälte mbB

(57) **Abstract**

The present disclosure discloses a system and method for optimization of energy consumption of a heating, ventilation, and air conditioning (HVAC) system in a data center is disclosed. The method comprises the step of receiving a plurality of inputs associated with a data center at predetermined intervals, wherein the plurality of inputs comprises manipulated variable (MV) inputs and disturbance variable (DV) inputs, determining, using a machine learning (ML) model, a plurality of output variables of the HVAC system, based on the MV inputs and the DV inputs, and predicting MV inputs for reducing the energy consumption of the HVAC system in the data center. The predicting comprises applying an optimization function on the plurality of output variables to generate the predicted MV inputs. The optimization function comprises plurality of parameters including Service level agreements (SLAs), total energy consumption of the HVAC system, and physics-based constraints.

## Description

### TECHNICAL FIELD

The present disclosure generally relates to energy optimization and more particularly, relates to systems and methods for optimization of energy consumption of a heating, ventilation, and air conditioning (HVAC) system in a data center.

### BACKGROUND

Large HVAC systems are used in data centers to ensure that IT equipment housed in them can function effectively. This entails using a massive amount of energy (in few megawatts) and leaves much scope for energy optimization. In the context of achieving net zero emissions, it is imperative to curb excess energy consumed by these HVAC systems. IT equipment in data centers is kept in strict temperature and relative humidity limits called service level agreements (SLAs). Accordingly, data center operators vary their HVAC system's set points to adhere to the SLAs.

The information disclosed in this background of the disclosure section is only for enhancement of understanding of the general background of the invention and should not be taken as an acknowledgement or any form of suggestion that this information forms the prior art already known to a person skilled in the art.

### SUMMARY

The present disclosure overcomes one or more shortcomings of the prior art and provides additional advantages discussed throughout the present disclosure. Additional features and advantages are realized through the techniques of the present disclosure. Other embodiments and aspects of the disclosure are described in detail herein and are considered a part of the claimed disclosure.

In one non-limiting embodiment of the present disclosure, a method for optimization of energy consumption of a heating, ventilation, and air conditioning (HVAC) system in a data center is disclosed. The method comprises the step of receiving a plurality of inputs associated with a data center at predetermined intervals. The plurality of inputs comprises manipulated variable (MV) inputs and disturbance variable (DV) inputs. The method then comprises the step of determining, using a machine learning (ML) model, a plurality of output variables of a heating, ventilation, and air conditioning (HVAC) system, based on the MV inputs and the DV inputs. The method finally discloses the step of predicting MV inputs for reducing the energy consumption of the HVAC system in the data center. The predicting includes applying an optimization function on the plurality of output variables to generate the predicted MV inputs. The optimization function comprises plurality of parameters including Service level agreements (SLAs), total energy consumption of the HVAC system, and physics-based constraints, and the optimization function defines a respective weight for a corresponding parameter of the plurality of parameters.

In another embodiment of the present disclosure, a system for optimization of energy consumption of a heating, ventilation, and air conditioning (HVAC) system in a data center is disclosed. The system includes a memory and at least one processor coupled to the memory. The at least one processor is configured to receive a plurality of inputs associated with a data center at predetermined intervals. The plurality of inputs comprises manipulated variable (MV) inputs and disturbance variable (DV) inputs. The at least one processor is then configured to determine, using a machine learning (ML) model, a plurality of output variables of a heating, ventilation, and air conditioning (HVAC) system based on the MV inputs and the DV inputs and predict MV inputs for reducing the energy consumption of the HVAC system in the data center. To predict the at least one processor is configured to apply an optimization function on the plurality of output variables to generate the predicted MV inputs. The optimization function comprises plurality of parameters including Service level agreements (SLAs), total energy consumption of the HVAC system, and physics-based constraints, and the optimization function defines a respective weight for a corresponding parameter of the plurality of parameters.

The foregoing summary is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE DRAWINGS

The accompanying drawings, which are incorporated in and constitute a part of this disclosure, illustrate exemplary embodiments and, together with the description, serve to explain the disclosed principles. The same numbers are used throughout the figures to reference like features and components. Some embodiments of device and/or methods in accordance with embodiments of the present subject matter are now described, by way of example only, and with reference to the accompanying drawings, in which:
**FIG. 1** illustrates an exemplary implementation of a heating, ventilation, and air conditioning (HVAC) system in a data center, in accordance with an embodiment of the present disclosure;
**FIG. 2** illustrates a block diagram for determining output variables of a heating, ventilation, and air conditioning (HVAC) system using a machine learning (ML) model, in accordance with an embodiment of the present disclosure;
**FIG. 3** illustrates a block diagram representation for optimization of energy consumption of a heating, ventilation, and air conditioning (HVAC) system in a data center, in accordance with another embodiment of the present disclosure;
**FIG. 4** illustrates a block diagram representation of system for optimization of energy consumption of a heating, ventilation, and air conditioning (HVAC) system in a data center, in accordance with another embodiment of the present disclosure; and
**FIG. 5** is a flowchart illustrating a method for optimization of energy consumption of a heating, ventilation, and air conditioning (HVAC) system in a data center, in accordance with an embodiment of the present disclosure.

It should be appreciated by those skilled in the art that any block diagrams herein represent conceptual views of illustrative systems embodying the principles of the present subject matter. Similarly, it will be appreciated that any flow charts, flow diagrams, state transition diagrams, pseudo code, and the like represent various processes which may be substantially represented in computer readable medium and executed by a computer or processor, whether or not such computer or processor is explicitly shown.

### DETAILED DESCRIPTION

In the present document, the word "exemplary" is used herein to mean "serving as an example, instance, or illustration". Any embodiment or implementation of the present subject matter described herein as "exemplary" is not necessarily to be construed as preferred or advantageous over other embodiments.

While the disclosure is susceptible to various modifications and alternative forms, specific embodiment thereof has been shown by way of example in the drawings and will be described in detail below. It should be understood, however that it is not intended to limit the disclosure to the particular forms disclosed, but on the contrary, the disclosure is to cover all modifications, equivalents, and alternative falling within the spirit and the scope of the disclosure.

The terms "comprises", "comprising", or any other variations thereof, are intended to cover a non-exclusive inclusion, such that a setup, device, or method that comprises a list of components or steps does not include only those components or steps but may include other components or steps not expressly listed or inherent to such setup or device or method. In other words, one or more elements in a device or system or apparatus proceeded by "comprises... a" does not, without more constraints, preclude the existence of other elements or additional elements in the device or system or apparatus.

In the following detailed description of the embodiments of the disclosure, reference is made to the accompanying drawings that form a part hereof, and in which are shown by way of illustration specific embodiments in which the disclosure may be practiced. These embodiments are described in sufficient detail to enable those skilled in the art to practice the disclosure, and it is to be understood that other embodiments may be utilized and that changes may be made without departing from the scope of the present disclosure. The following description is, therefore, not to be taken in a limiting sense.

The terminologies "Machine model" and "ML model" have been interchangeably used throughout the specification.

The terminologies "heating, ventilation, and air conditioning system" and "HVAC system" have been interchangeably used throughout the specification.

The terminologies "computer room air conditioning" and "CRAC" have been interchangeably used throughout the specification.

The terminologies "manipulated variable inputs", "MV inputs", and "MVs" have been interchangeably used throughout the specification. The MV inputs are inputs which may be controlled by operators of the HVAC plant or HVAC system.

The terminologies "disturbance variable inputs", "DV inputs", and "DVs" have been interchangeably used throughout the specification. The DV inputs are external factors outside the control of operators that influence the state of the HVAC system.

The terminologies "evaluation objectives", "evaluation parameters", and "parameters" have been interchangeably used throughout the specification.

The terminologies "optimization function", and "objective function" have been interchangeably used throughout the specification.

Lowering energy consumed by a heating, ventilation, and air conditioning (HVAC) system in a data center is not trivial, as several factors must be considered such as the environmental conditions, operational IT equipment, and the strict service level agreements (SLAs) imposed on the data center operators. Prior approaches attempted to lower the energy consumption by mostly relying on physics-based models and controllers. This is often a computationally expensive process and may not be viable in near real time applications.

Presently, data center operators vary their HVAC system's set points to adhere to SLAs. Challenges with manually operating a data center includes reducing energy consumption becomes tedious, hotspots in server rooms cannot be easily managed, and identifying bad actors in the HVAC system becomes difficult.

HVACs can be powered through renewable energy, but this does not address the these issues listed above. Others focused on control strategies using complex physics solvers, using optimization to reduce the cooling load of an HVAC system. Another control strategy leveraged a physics model such as EnergyPlus that builds a Reinforcement Learning (RL) based control strategy controlling only a handful of temperature set points in the HVAC system.

Due to time restrictions, physics solvers cannot be used in real time applications and the physics solvers do not model the entire HVAC system. Machine learning (ML) frameworks/models have also been used to model data centers. These ML models estimate the power usage effectiveness of the data center and but these models fail to provide strategy accounted for SLA violations.

Thus, physics models are accurate, yet slow and ML models, while fast, don't model the dynamics of the system. Combining optimization and ML is common across industries. In operations research, a framework is developed that uses predictions from an ML model to solves an optimization problem. This framework utilizes statistical principles to produce a new ML model which will then be used for decision making. Hower, this approach does not account for poor predictions from the underlying ML model, nor does this approach include any physics constraints.

In view of the foregoing discussion, there exists a need in the art to provide a method and a system which overcomes the above stated problems by efficiently combining optimization, ML and physics knowledge, address inaccuracies in ML models, and can handle uncertainties in data center operations.

The present disclosure discloses a system and method for optimization of energy consumption of a heating, ventilation, and air conditioning (HVAC) system in a data center is disclosed. The method comprises the step of receiving a plurality of inputs associated with a data center at predetermined intervals, wherein the plurality of inputs comprises manipulated variable (MV) inputs and disturbance variable (DV) inputs, determining, using a machine learning (ML) model, a plurality of output variables of the HVAC system, based on the MV inputs and the DV inputs, and predicting MV inputs for reducing the energy consumption of the HVAC system in the data center. The predicting includes applying an optimization function on the plurality of output variables to generate the predicted MV inputs. The optimization function comprises plurality of parameters including Service level agreements (SLAs), total energy consumption of the HVAC system, and physics-based constraints. Thus, the method facilitates energy savings in terms of cooling load, addresses hotspots in cold aisles, identifies bad actors in the system, provides enhanced stability of the system by adhering to SLAs.

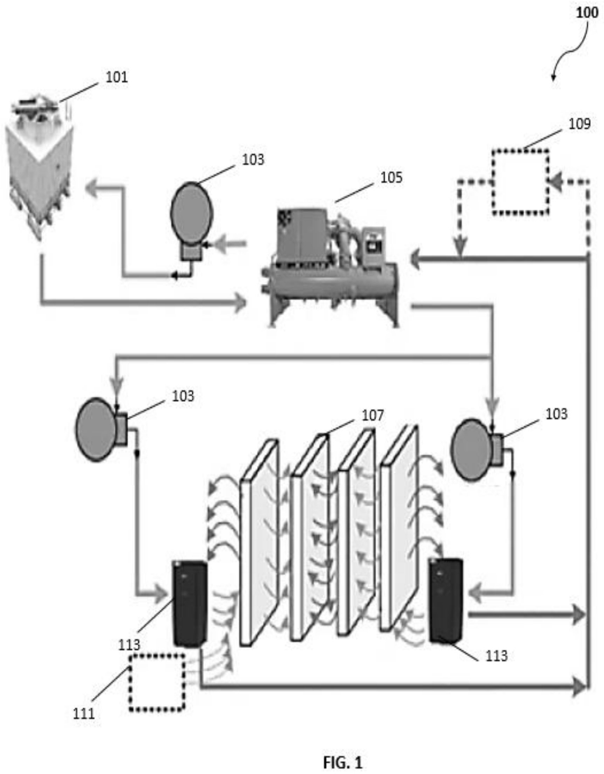

**FIG. 1** illustrates an exemplary implementation of a heating, ventilation, and air conditioning (HVAC) system 100 in a data center, in accordance with an embodiment of the present disclosure.

In an embodiment of the present disclosure, the HVAC system 100 may be implemented in a server room or data centers 107. The server room or data center 107 may be a space dedicated within premises designed to house and manage the information technology (IT) infrastructure, particularly servers and networking equipment. The data centers 107 centralize organizations' IT operations and equipment to ensure a secure location for storing, sharing, and managing vast amounts of data.

The HVAC system 100 may be implemented at the data center 107 to maintain strict temperature and relative humidity limits called service level agreements (SLAs). The HVAC system 100 may comprise cooling tower 101, one or more pumps 103, a chiller 105, a waterside economizer 109, an airside economizer 111, and computer room air handlers (CRAHs) 113. In an aspect of the present disclosure, the HVAC system 100 is not limited to above mentioned components and any other necessary component that maintains strict temperature and relative humidity limits and known to a person skilled is well within the scope of the present disclosure.

In an embodiment, the cooling tower 101 may as a heat exchanger that use water and air to transfer heat from air-conditioning systems to the outdoor environment. The cooling tower 101 may be used to remove heat from the condenser water leaving a chiller 105. Cooling tower 101 may be located on rooftops or other outdoor sites.

The one or more pumps 103 may be configured to assist in maintaining optimal temperature levels and ensuring efficient operation in the HVAC system 100. These pumps are responsible for circulating the system fluid to enable the transfer of heat and enabling the cooling process.

The chiller 105 may act as a cooling system designed to remove heat from a liquid, being circulate, and then circulate the chilled liquid through a building or facility to absorb heat, ensuring efficient cooling of the data center 107. In an embodiment, a required number of chillers may be implemented based on the size and capacity of the data center 107.

In an embodiment, the waterside economizer 109 may use the evaporative cooling capacity of the cooling tower 101 to produce chilled water. The airside economizer 111 may comprise a duct and damper arrangement with a controller that enables the HVAC system 100 to use outdoor air to meet the cooling load when outdoor conditions are favorable.

In an embodiment, the CRAHs 113 may be in close vicinity of the data centers 107 and may be configured to facilitate the cooling of the data center 107 by cooling the air using a cooling coil filled with chilled water. The water is supplied to the CRAH 113 from chiller 105 to provide necessary cooling.

The present disclosure describes optimization of energy consumption of the HVAC system 100 in the data center. The optimization is achieved by predicting manipulated variable (MV) inputs of the HVAC system for reducing the energy consumption of the HVAC system 101 in the data center. The MV input are predicted to meets Service level agreements (SLAs), total energy consumption requirement of the HVAC system, and physics-based constraints. Thus, application of the predicted MV inputs to the HVAC system facilitates energy savings in terms of cooling load, addresses hotspots in cold aisles, identifies bad actors in the system, provides enhanced stability of the system by adhering to SLAs.

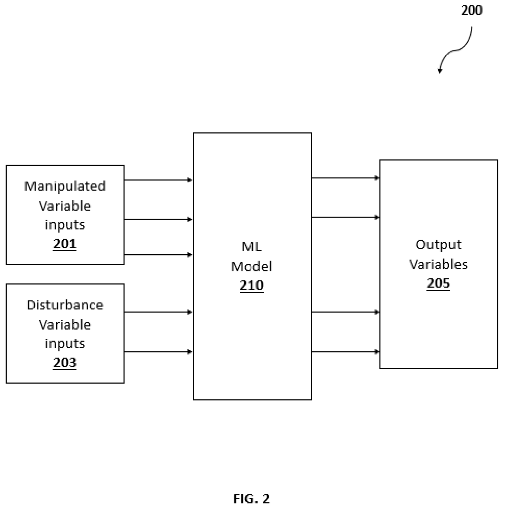

**FIG. 2** illustrates a block diagram 200 for determining output variables of HVAC system using a machine learning (ML) model, in accordance with an embodiment of the present disclosure.

In an embodiment of the present disclosure, a machine learning (ML) model 210 may be trained with plurality of historical data set of the HVAC system. Each training data set may comprise historical manipulated variable (MV) inputs, the historical disturbance (DV) inputs, and corresponding historical output variables. The MV inputs are inputs which can be controlled by operators of the HVAC plant, while DV inputs are external factors outside the control of operators that influence the state of the HVAC system. Essentially, these inputs comprise of variables that will have impact on the data center while the outputs are observed effects of the inputs.

For example, the MV inputs at least include set points of each equipment class in the HVAC system including chiller, pumps, cooling tower, and computer room air conditioning (CRAC) and the DV inputs may at least include environmental conditions and Information Technology (IT) load. The output variables may at least comprise temperature and humidity condition of each zone of the data center, condenser water output, chiller output, and power consumption of equipment present in the HVAC system.

However, the MV inputs, the DV inputs, and the output variables are not limited to above example and may include additional variables based on the HVAC deployed at the data center.

In an embodiment, the ML model 210 may be trained with historical data set to derive a correlation between the MV inputs, the DV inputs, and the output variables of the HVAC system. This correlation may be used determine real-time output variables of the HVAC system for a given set of MV inputs and DV inputs. In one non-limiting embodiment, the ML model 210 may be trained with one or more physics-based constraints so that the output variables determined by the ML model adhere to the laws of physics.

As shown in fig. 2, the ML model 210 may be configured to receive MV inputs 201 that includes the set points of equipment's of HVAC system and current DV inputs reflecting the environmental condition and current IT load present at the data center. The ML model 210 may be configured to determine the output variables 205 of the HVAC system, using the derived correlation.

In an embodiment, the MV inputs may be varied to change output variables of HVAC system and to facilitate energy optimization. Hence, the present disclosure describes an optimization function for adjustment of the MV inputs that lead to energy optimization. The optimization function is discussed in detail in below embodiments.

In an embodiments, the ML model 210 may be a neural network or a deep learning model. However, the ML model 210 is not restricted to above example and any other artificial intelligence model which is modeled with the MV inputs, the DV inputs, the output variables, and the physics-based constraints is well within the scope of present disclosure.

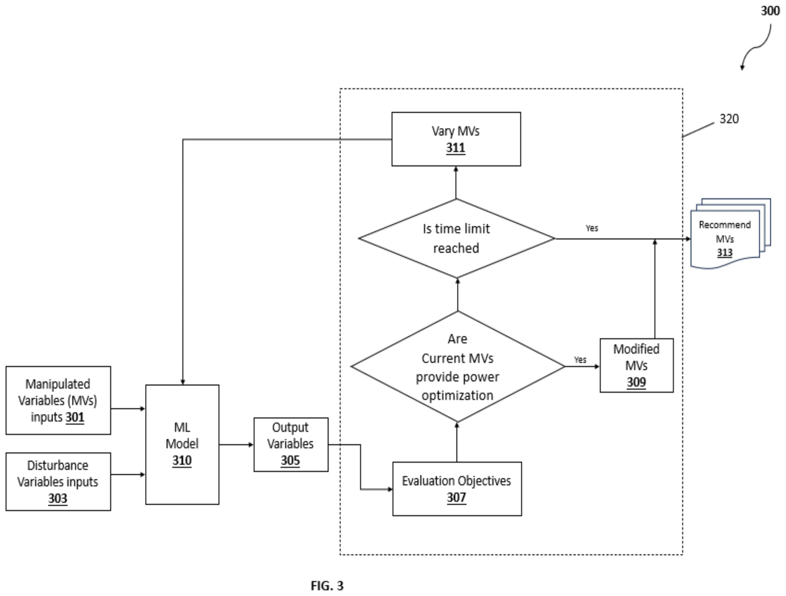

**FIG. 3** illustrates a block diagram representation for optimization of energy consumption of a heating, ventilation, and air conditioning (HVAC) system in a data center, in accordance with another embodiment of the present disclosure.

In an embodiment, a ML model 310 is integrated with an optimization model 320. The ML model 310 may be similar to ML model 210, as discussed in explanation of fig. 2. The ML model 310 may be trained in a manner as discussed in above embodiments. In an embodiment, the ML model 310 may serves as a function approximator of the data center and works in conjunction with the optimization model 320, as shown in fig. 3.

In an embodiment of the present disclosure, the optimization workflow begins with initialization of MV inputs 301 in the data center based on a current status of DV inputs 303 and historical data set of the HVAC system. In an embodiment, the status of DV inputs 303 is checked or obtained from the data center at regular interval for each optimization cycle. In one non-limiting embodiment, each optimization cycle may be of 30 minutes. However, the optimization cycle may be adjusted based on the amount of optimization required.

The MV inputs 301 for initialization is decided or determined based on the current environmental condition of the data center and current IT load status of the data center reflected by the current status of DV inputs 303. The current environmental condition of the data center and current IT load status of the data center may be compared with the historical data set of the HVAC system to determine the MV inputs 301.

During every optimization cycle, these MV inputs 301 and the current DV inputs 303 may be sent to the ML model 310. With these MV inputs 301 and the current DV inputs 303, the ML model 310 produces an output. The output may comprise a plurality of output variables. These plurality of output variables may be evaluated against the objective or optimization function defined by the optimization model 320.

In an embodiment of the present disclosure, the optimization model 320 may comprise a plurality of evaluation objectives or parameters 307. This plurality of parameters 307 may comprise adherence to Service level agreements (SLAs), minimization of total energy consumption of the HVAC system, and abiding by the law of conservation of energy i.e., physics-based constraints. In an embodiment, the plurality of parameters 307 may be used to define an optimization function of the optimization model 320.

In an embodiment of the present disclosure, the optimization function may be the driving force behind the optimization model 320. The optimization function may be defined as follows: $J = {α}_{SP} ∗ {J}_{SP} + {α}_{RH} \sum {J}_{SLA} + {α}_{H} ∗ \left[{J}_{P}\right]$
*J*: Final objective or optimization function,
*J_{SP}:* Computed system power objective function,
*Jⁱ _{SLA}:* Correction for deviations from SLAs,
*Jp:* Energy balance correction,
**α_{SP}**, **α_{RH}, α***_{H}*: defines a respective weight/ penalty for a corresponding parameter.

The equation (1) pushes the optimization model 320 to select "optimal" solution. The optimization function has the following components in the equation. Minimization of system power (*J_{SP}*): Adding this term along with a penalty/weight ensure that the optimization selects solutions whose system power (i.e., power consumed by the HVAC system of the data center) is less than the current unoptimized system power. Adherence to SLAs (Jⁱ_{SLA}): This term forces along with a penalty/weight ensures that the optimization picks solutions such that SLAs (temperature and relative humidity) in each room of the data center are not violated. Adherence to energy balance in the HVAC system (*Jp*): When a solution is produced by the optimization, the solution needs to abide by the laws of energy conservation (flow and mass rate). This term prohibits solutions that do not violate these laws.

In an embodiment of the present disclosure, the values for α_{SP}, α_{RH} and α_{H} are a function of the model prediction accuracy. In the event the prediction accuracy of the outputs of the neural network or the ML model 310 for the variables in the terms α_{SP}, α_{RH} and α_{H} are high, then the hierarchy is used to assign their values. In an exemplary hierarchy, α_{RH} is given the highest value since the most important outcome in a data center is to ensure the SLAs are never violated, α_{SP} is given the second highest value since the objective is to reduce the energy consumption of the data center (but not at the expense of SLA violations), and α_{H} is given the third highest value.

When the plurality of output variables is received from the ML model 310 in an optimization cycle for optimization, the above mentioned objective or optimization function is applied on the plurality of output variables to predict the modified MV inputs 309. If the modified MV inputs 309 provide power/energy optimization, the modified MV inputs 309 are selected for recommendation, which is also denoted as recommended MVs 313. If the modified MV inputs 309 do not provide power optimization, then modified MV inputs 309 varied till power optimization is achieved or for a predetermined time duration. In case the power optimization is not achieved in the predetermined time duration, then fail-safe measures may be recommended instead of the modified MV inputs 309. The fail-safe measures may include optimized inputs that may be determined based on the current status of the DV inputs 303 and historical data set of the HVAC system.

In one non-limiting embodiment of the present disclosure, the variation of the modified MV inputs 309 may be within a predetermined range and a variation outside the predetermined range may lead to recommendation of fail-safe measures, as discussed in above embodiments.

If the proposed solution does not meet all the objectives, a new set of MVs are generated based on the current set and these are re-fed to the model. This loop continues and the MVs are iteratively improved upon until all objectives are met. Once a configured time limit is reached, the optimization will stop and the updated MVs are applied to the system.

Thus, the predicted MV inputs to the HVAC system facilitates energy savings in terms of cooling load, addresses hotspots in cold aisles, and provides enhanced stability of the system by adhering to SLAs.

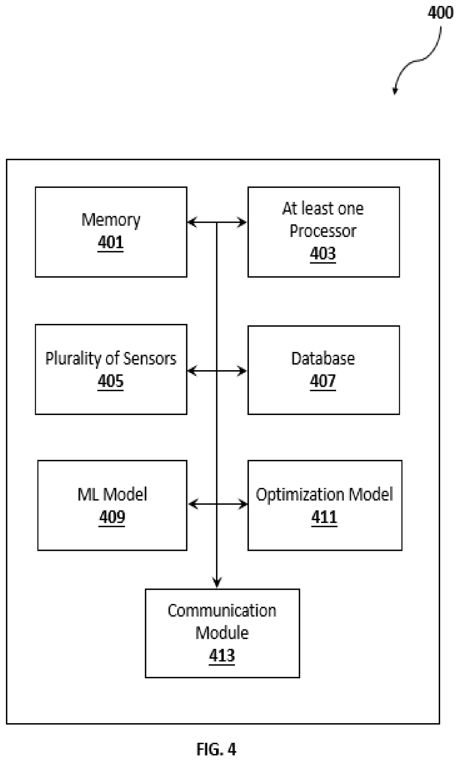

**FIG. 4** illustrates a block diagram representation of system 400 for optimization of energy consumption of a heating, ventilation, and air conditioning (HVAC) system in a data center, in accordance with another embodiment of the present disclosure.

In an embodiment, the system 400 may comprise a memory 401, at least one processor 403, plurality of sensors 405, database 407, a machine learning (ML) model 409 and an optimization model 411, and a communication module 413. In an embodiment, the system 400 may be integrated with the HVAC system in a data center, as discussed in above embodiments. In one non-limiting embodiment, the memory 301 and at least one processor 303 may perform all the functionalities of the system 400, as discussed in above embodiments.

The at least one processor 403 may include Central Processing Units (also referred as "CPUs" or "a processor 206"), may be coupled Input/ Output (I/O) interface (not shown), and a memory 401. In some embodiments, the memory 410 may be communicatively coupled to the at least one processor 403. The memory 401 stores instructions executable by the processor 206. The at least one processor 403 may comprise at least one data processor for executing program components for executing user or system-generated requests. The memory 401 stores instructions, executable by the at least one processor 403, which, on execution, may cause the at least one processor 403 to optimize energy consumption of the HVAC system. In an embodiment, the ML model 409 and the optimization model 411 may be configured to perform the steps of the present disclosure. In an embodiment, each of the ML model 409 and the optimization model 411 may be a hardware unit which may be coupled with the at least one processor 403. As used herein, the term ML model 409 and optimization model 411 refers to an Application Specific Integrated Circuit (ASIC), an electronic circuit, a Field-Programmable Gate Arrays (FPGA), Programmable System-on-Chip (PSoC), a combinational logic circuit, and/or other suitable components that provide described functionality. The ML model 409 and the optimization model 411 when configured with the described functionality defined in the present disclosure will result in a novel hardware. Further, the I/O interface is coupled with the at least one processor 403 through which an input signal or/and an output signal is communicated.

In one implementation, the communication module 413 may comprise a transmitter and a receiver. The communication module 413 may include antennas, transceivers, network interface controllers (NICs), and the like to transmit and receive data. For instance, the transmitter of the communication module 413 may be configured to transmit optimized manipulated variables (MV) inputs for the HVAC system to one or more operators in the HVAC system or digital control system of the HVAC system. The receiver of the communication module 413 may be configured to receive initial MV inputs for optimization of energy consumption at HVAC system. Further, the communication module 218 may comprise protocol handling units such as Transmission Control Protocol/Internet Protocol (TCP/IP), User Datagram Protocol (UDP) etc. The protocol handling units may be configured for encoding or decoding data, routing of data, etc. Also, the communication module 413 may include interfaces such as serial ports, ethernet ports, etc. The communication module 413 may include a signal pre-processing unit to eliminate noise from the data. The communication module 413 may transfer the data to the memory 401 of the system 400. A person skilled in the art will appreciate that the communication module 413 may comprise fewer or additional components, and the above-mentioned components should not be considered as limiting.

The at least one processor 403 may be configured to receive a plurality of inputs associated with the data center at predetermined intervals. The predetermined interval may be decided based on amount of energy optimization required. The plurality of inputs comprises manipulated variable (MV) inputs and disturbance variable (DV) inputs. The MV inputs are inputs which can be controlled by operators of the HVAC system, while DV inputs are external factors outside the control of operators that influence the state of the HVAC system.

In an embodiment, the MV inputs at least include set points of each equipment class in the HVAC system including chiller, pumps, cooling tower, and computer room air conditioning (CRAC) and the DV inputs at least include environmental conditions and Information Technology (IT) load. In one non-limiting embodiment, the environmental conditions of the data center may be captured using the plurality of sensors 405 deployed at the data center.

In an embodiment, to receive the MV inputs associated with the data center, the at least one processor 403 may be configured to initialize the MV inputs of the HVAC system in the data center at least based on a current status of the DV inputs and historical data set of the HVAC system. For example, best set of MV inputs for a given operating condition indicated by the DV inputs. In one non-limiting embodiment, the historical data set of the HVAC system may be stored in the database 407.

In case outlier and/or missing variable is detected by the at least one processor 403, the at least one processor 403 may be configured to apply at least imputation technique to impute variable in place of the at least one detected outlier and/or missing variable. The historical data set may define "healthy range" of values associated with each variable. In an embodiment, a historical data set of most-recently observed health data is maintained for each variable and used for imputation. In another embodiment, in the absence of healthy data, the imputation technique may fetch the last observed healthy data for a variable from this historical data set.

However, the imputation technique is not limited to above example, and any other imputation technique known to a person skilled in the art is well within the scope of present disclosure.

The at least one processor 403 may be configured to determine, using the ML model 409, a plurality of output variables of the HVAC system, based on the MV inputs and the DV inputs. The plurality of output variables comprises temperature and humidity condition of each zone of the data center, condenser water output, chiller output, and power consumption of equipment present in the HVAC system. However, the plurality of output variables is not limited to above stated examples and may vary based on the HVAC system deployed at the data center.

In an embodiment, for determination of the plurality of output variables, the at least one processor 403 may be configured to train the ML model with historical data set of the HVAC system in the data center for defined Service level agreements (SLAs) and derive a correlation between the plurality of inputs and the plurality of output variables. In one non-limiting embodiment, the at least one processor 403 may be configured to train ML model further based on one or more physics-based constraints to abide the determined output variables within the law of conservation of energy.

The at least one processor 403 may be then configured to predict MV inputs for reducing the energy consumption of the HVAC system in the data center, at least based on the optimization or objective function, as discussed in explanation of fig. 3. For the prediction, the at least one processor 403 may be configured to apply an optimization function on the plurality of output variables to generate the predicted MV inputs.

In an embodiment, the optimization function comprises plurality of parameters including Service level agreements (SLAs), total energy consumption of the HVAC system, and physics-based constraints, and the optimization function defines a respective weight for a corresponding parameter of the plurality of parameters. The optimization function may be implemented using the optimization model 411.

In an embodiment, to apply the optimization function, the at least one processor 403 may be configured to predict, using the optimization function, modified MV inputs for the HVAC system for a predetermined time duration. The at least one processor 403 may be then configured to determine whether the predicted MV inputs satisfies a predetermined power reduction requirement while adhering to the SLAs and the physics-based constraints.

If the predicted MV inputs fails to satisfy the predetermined power reduction requirement within the predetermined time duration, then the at least one processor 403 may be configured to recommend fail-safe measures corresponding to a current status of the DV inputs. This recommendation includes determination of optimized MV inputs based on the current status of the DV inputs and the historical data set of the HVAC system.

If the predicted MV inputs satisfies the predetermined power reduction requirement, the at least one processor 403 may be configured to recommend the predicted MV inputs as the optimized MV inputs for the HVAC system. Further, if a difference between the predicted MV inputs and a previous set of MV inputs is not within a predefined range of respective MV inputs, the at least one processor 403 may be configured to recommend fail-safe measures including the optimized MV inputs corresponding to the current status of the DV inputs or continue with the previous set of MV inputs as the optimized MV inputs corresponding to the current status of the DV inputs. The one of the above operations may be pre-decided by an operator of the HVAC system.

In an embodiment, the at least one processor 403 may be configured to recommend the predicted MV inputs to the operator of the HVAC system in case of manually operated HVAC system and to a digital control system in case of autonomous HVAC system. The predicted MV inputs of the HVAC system facilitates energy savings in terms of cooling load, addresses hotspots in cold aisles, identifies bad actors in the system, provides enhanced stability of the system by adhering to SLAs.

In one non-limited embodiment, the at least one processor 403 may be configured to monitor the determined plurality of output variables of the HVAC system and detect a deviation in at least one output variable of the plurality of output variables at least based on corresponding deviation threshold. The deviation in the output variable may indicate a degradation of the ML model 409. In such scenario, the at least one processor 403 may be configured to modify a weight of parameter of the optimization function mapped to the at least one output variable based on the deviation in the at least one output variable. This shall modify the output of the optimization function defined in the optimization model 411 and compensate for inaccurate output variable of the ML model 409.

In one non-limiting embodiment, the data center is divided into plurality of zones or hotspots. And the SLAs may comprises an SLA for each zone. In such situation, the at least one processor 403 may be configured to monitor, in real-time, sensor data of each of the plurality of zones within the data center, detect a deviation of the sensor data from corresponding SLAs of the at least one zone, apply the optimization function to predict MV inputs for the at least one zone to meet the corresponding set of SLAs, based on the detected deviation of the sensor data, and recommend the predicted MV inputs as an optimized MV inputs for the at least one zone.

Given the different processes these servers run, the heat generated by different servers may be different. As a result, there may be pockets in the data center which may be hotter than other zones. This is an undesirable outcome for the operators and to combat this, the present disclosure may apply the rules including using sensor data to zero-in on zones which are hot pockets, using the layout information of the data center to identify ACs closest to these hotspots, selectively manipulate the ACs inside the data center to avoid these zones.

Thus, the system 400 facilitates energy savings in terms of cooling load, addresses hotspots in cold aisles, identifies bad actors in the system, provides enhanced stability of the system by adhering to SLAs.

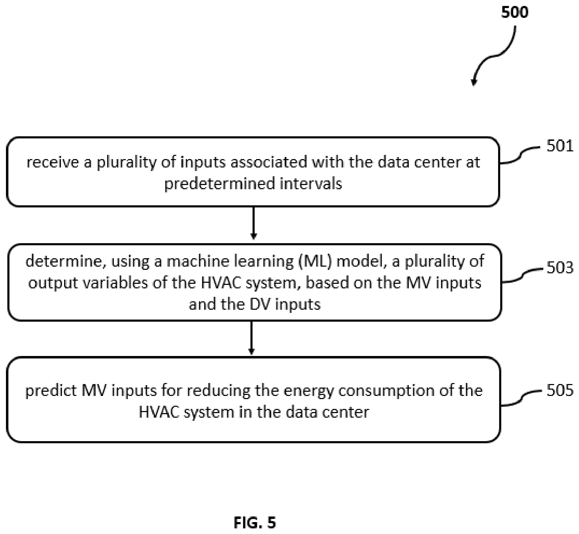

**FIG. 5** is a flowchart illustrating a method for optimization of energy consumption of a heating, ventilation, and air conditioning (HVAC) system in a data center, in accordance with an embodiment of the present disclosure.

The method 500 depicted in the flow diagram may be performed by, for example, the at least one processor 403 shown in fig. 4. Operations of the flow diagram, and combinations of operation in the flow diagram, may be implemented by, for example, hardware, firmware, a processor, circuitry, and/or a different device associated with the execution of software that includes one or more computer program instructions. It is noted that the operations of the method 500 can be described and/or practiced by using one or more processors of a system/device other than discussed in above embodiments.

At block 501, the method 500 discloses receiving a plurality of inputs associated with the data center at predetermined intervals. The predetermined interval may be decided based on amount of energy optimization required. The plurality of inputs comprises manipulated variable (MV) inputs and disturbance variable (DV) inputs. The MV inputs are inputs which can be controlled by operators of the HVAC system, while DV inputs are external factors outside the control of operators that influence the state of the HVAC system.

In an embodiment, the MV inputs at least include set points of each equipment class in the HVAC system including chiller, pumps, cooling tower, and computer room air conditioning (CRAC) and the DV inputs at least include environmental conditions and Information Technology (IT) load. In one non-limiting embodiment, the environmental conditions of the data center may be captured using the plurality of sensors deployed at the data center.

In an embodiment, for receiving the MV inputs associated with the data center, the method 500 comprises initializing the MV inputs of the HVAC system in the data center at least based on a current status of the DV inputs and historical data set of the HVAC system. For example, best set of MV inputs for a given operating condition indicated by the DV inputs. In one non-limiting embodiment, the historical data set of the HVAC system may be stored in a database.

In case outlier and/or missing variable is detected, the method 500 may comprise applying at least imputation technique to impute variable in place of the at least one detected outlier and/or missing variable. The historical data set may define "healthy range" of values associated with each variable. In an embodiment, a historical data set of most-recently observed health data is maintained for each variable and used for imputation. In another embodiment, in the absence of healthy data, the imputation technique may fetch the last observed healthy data for a variable from this historical data set.

However, the imputation technique is not limited to above example, and any other imputation technique known to a person skilled in the art is well within the scope of present disclosure.

At block 503, the method 500 discloses determining, using the ML model, a plurality of output variables of the HVAC system, based on the MV inputs and the DV inputs. The plurality of output variables comprises temperature and humidity condition of each zone of the data center, condenser water output, chiller output, and power consumption of equipment present in the HVAC system. However, the plurality of output variables is not limited to above stated examples and may vary based on the HVAC system deployed at the data center.

In an embodiment, for determining the plurality of output variables, the method 500 may comprise training the ML model with historical data set of the HVAC system in the data center for defined Service level agreements (SLAs) and deriving a correlation between the plurality of inputs and the plurality of output variables. In one non-limiting embodiment, the method 500 may further comprise training ML model further based on one or more physics based constraints to abide the determined output variables within the law of conservation of energy.

At block 505, the method 500 discloses predicting MV inputs for reducing the energy consumption of the HVAC system in the data center, at least based on the optimization or objective function, as discussed in explanation of fig. 3. For the prediction, the method 500 may comprise applying an optimization function on the plurality of output variables to generate the predicted MV inputs.

In an embodiment, the optimization function comprises plurality of parameters including Service level agreements (SLAs), total energy consumption of the HVAC system, and physics-based constraints, and the optimization function defines a respective weight for a corresponding parameter of the plurality of parameters. The optimization function may be implemented using the optimization model.

In an embodiment, for applying the optimization function, the method 500 may comprise predicting, using the optimization function, modified MV inputs for the HVAC system for a predetermined time duration. The method 500 may comprise determining whether the predicted MV inputs satisfies a predetermined power reduction requirement while adhering to the SLAs and the physics-based constraints.

If the predicted MV inputs fails to satisfy the predetermined power reduction requirement within the predetermined time duration, then the method 500 may comprise recommending fail-safe measures corresponding to a current status of the DV inputs. This recommending includes determining of optimized MV inputs based on the current status of the DV inputs and the historical data set of the HVAC system.

If the predicted MV inputs satisfies the predetermined power reduction requirement, the method 500 may comprise recommending the predicted MV inputs as the optimized MV inputs for the HVAC system. Further, if a difference between the predicted MV inputs and a previous set of MV inputs is not within a predefined range of respective MV inputs, the method 500 may comprise recommending fail-safe measures including the optimized MV inputs corresponding to the current status of the DV inputs or continuing with the previous set of MV inputs as the optimized MV inputs corresponding to the current status of the DV inputs. The one of the above operation may be pre-decided by an operator of the HVAC system.

In an embodiment, the method 500 may further comprise recommending the predicted MV inputs to the operator of the HVAC system in case of manually operated HVAC system and to a digital control system in case of autonomous HVAC system. The predicted MV inputs of the HVAC system facilitates energy savings in terms of cooling load, addresses hotspots in cold aisles, identifies bad actors in the system, provides enhanced stability of the system by adhering to SLAs.

In one non-limited embodiment, the method 500 may comprise monitoring the determined plurality of output variables of the HVAC system and detect a deviation in at least one output variable of the plurality of output variables at least based on corresponding deviation threshold. The deviation in the output variable may indicate a degradation of the ML model. In such scenario, the method 500 may comprise to modifying a weight of parameter of the optimization function mapped to the at least one output variable based on the deviation in the at least one output variable. This shall modify the output of the optimization function defined in the optimization model and compensate for inaccurate output variable of the ML model.

In one non-limiting embodiment, the data center is divided into plurality of zones or hotspots. And the SLAs may comprise an SLA for each zone. In such situation, the method 500 may comprise monitoring, in real-time, sensor data of each of the plurality of zones within the data center, detecting a deviation of the sensor data from corresponding SLAs of the at least one zone, applying the optimization function to predict MV inputs for the at least one zone to meet the corresponding set of SLAs, based on the detected deviation of the sensor data, and recommending the predicted MV inputs as an optimized MV inputs for the at least one zone.

Thus, the method 500 facilitates energy savings in terms of cooling load, addresses hotspots in cold aisles, identifies bad actors in the system, provides enhanced stability of the system by adhering to SLAs.

The disclosed method with reference to FIG. 5, or one or more operations of the flow diagram 500 may be implemented using software including computer-executable instructions stored on one or more computer-readable media (e.g., non-transitory computer-readable media, such as one or more optical media discs, volatile memory components (e.g., DRAM or SRAM), or non-volatile memory or storage components (e.g., hard drives or solid-state non-volatile memory components, such as Flash memory components) and executed on a computer (e.g., any suitable computer, such as a laptop computer, net book, Web book, tablet computing device, smart phone, or other mobile computing device). Such software may be executed, for example, on a single local computer.

Various embodiments of the present disclosure provide numerous advantages. Embodiments of the present disclosure provide a system for analyzing cybersecurity postures for an operation technology infrastructure. In addition, the present disclosure provides the system for generating a prioritization sequence for remediation of one or more vulnerable components of each plant.

It will be understood by those within the art that, in general, terms used herein, and are generally intended as "open" terms (e.g., the term "including" should be interpreted as "including but not limited to," the term "having" should be interpreted as "having at least," the term "includes" should be interpreted as "includes but is not limited to," etc.). For example, as an aid to understanding, the detail description may contain usage of the introductory phrases "at least one" and "one or more" to introduce recitations. However, the use of such phrases should not be construed to imply that the introduction of a recitation by the indefinite articles "a" or "an" limits any particular part of description containing such introduced recitation to inventions containing only one such recitation, even when the introductory phrases "one or more" or "at least one" and indefinite articles such as "a" or "an" (e.g., "a" and/or "an" should typically be interpreted to mean "at least one" or "one or more") are included in the recitations; the same holds true for the use of definite articles used to introduce such recitations. In addition, even if a specific part of the introduced description recitation is explicitly recited, those skilled in the art will recognize that such recitation should typically be interpreted to mean at least the recited number (e.g., the bare recitation of "two recitations," without other modifiers, typically means at least two recitations or two or more recitations).

Further disclosed herein is the subject matter of the following clauses:
Clause 1. A method for optimization of energy consumption of a heating, ventilation, and air conditioning (HVAC) system in a data center, the method comprising:
   receiving a plurality of inputs associated with a data center at predetermined intervals, wherein the plurality of inputs comprises manipulated variable (MV) inputs and disturbance variable (DV) inputs;
   determining, using a machine learning (ML) model, a plurality of output variables of a heating, ventilation, and air conditioning (HVAC) system, based on the MV inputs and the DV inputs; and
   predicting MV inputs for reducing the energy consumption of the HVAC system in the data center,
   wherein predicting comprises applying an optimization function on the plurality of output variables to generate the predicted MV inputs, and
   wherein the optimization function comprises a plurality of parameters including Service level agreements (SLAs), total energy consumption of the HVAC system, and physics-based constraints, and wherein the optimization function defines a respective weight for a corresponding parameter of the plurality of parameters.
Clause 2. The method of clause 1, wherein the MV inputs at least include set points corresponding to each equipment class in the HVAC system including chiller, pumps, cooling tower, and computer room air conditioning (CRAC), and wherein the DV inputs comprises at least environmental conditions and Information Technology (IT) load.
Clause 3. The method of any one of clauses 1 and 2, wherein the plurality of output variables comprises temperature and humidity condition of each zone of the data center, condenser water output, chiller output, and power consumption of equipment present in the HVAC system.
Clause 4. The method of any one of clauses 1 through 3, wherein applying the optimization function comprises:
   predicting, using the optimization function, modified MV inputs for the HVAC system for a predetermined time duration;
   determining whether the predicted MV inputs satisfies a predetermined power reduction requirement while adhering to the SLAs and the physics-based constraints;
   recommending fail-safe measures corresponding to a current status of the DV inputs, in case the predicted MV inputs fails to satisfy the predetermined power reduction requirement within the predetermined time duration, wherein recommending the fail-safe measures comprises determining optimized MV inputs based on the current status of the DV inputs and historical data set of the HVAC system; and
   recommending the predicted MV inputs as the optimized MV inputs for the HVAC system, in case the predicted MV inputs satisfies the predetermined power reduction requirement.
Clause 5. The method of clause 4, further comprising:
   determining whether a difference between the predicted MV inputs and a previous set of MV inputs is within a predefined range of respective MV inputs; and
   in case the determined difference is outside the predefined range of respective MV inputs:
      recommending fail-safe measures including the optimized MV inputs corresponding to the current status of the DV inputs, or
      continuing with the previous set of MV inputs as the optimized MV inputs corresponding to the current status of the DV inputs.
Clause 6. The method of any one of clauses 1 through 5, further comprising:
   recommending the predicted MV inputs to an operator of the HVAC system or a digital control system of the HVAC system.
Clause 7. The method of any one of clauses 1 through 6, further comprising:
   monitoring the determined plurality of output variables of the HVAC system;
   detecting a deviation in at least one output variable of the plurality of output variables at least based on corresponding deviation threshold; and
   modifying a weight of parameter of the optimization function mapped to the at least one output variable based on the deviation in the at least one output variable.
Clause 8. The method of any one of clauses 1 through 7, wherein the data center is divided into plurality of zones, wherein the SLAs comprises a set of SLAs for each zone, and wherein the method further comprises:
   monitoring, in real-time, sensor data of each of the plurality of zones within the data center,
   detecting a deviation of the sensor data from corresponding SLAs of the at least one zone;
   applying the optimization function to predict MV inputs for the at least one zone to meet the corresponding set of SLAs, based on the detected deviation of the sensor data; and
   providing the predicted MV inputs as an optimized MV inputs for the at least one zone.
Clause 9. The method of any one of clauses 1 through 8, further comprising:
   initializing the MV inputs of the HVAC system in the data center at least based on a current status of the DV inputs and historical data set of the HVAC system.
Clause 10. The method of any one of clauses 1 through 9, further comprising:
   detecting at least one outlier and/or missing variable in the MV inputs and the DV inputs; and
   applying at least imputation technique to impute variable in place of the at least one detected outlier and/or missing variable.
Clause 11. The method of any one of clauses 1 through 10, further comprising:
   training the ML model with historical data set of the HVAC system in the data center for defined Service level agreements (SLAs), wherein the historical data set comprising historical MV inputs, the historical DV inputs, and corresponding historical output variables.
Clause 12. The method of clause 12, further comprising:
   training the ML model further based on one or more physics-based constraints.
Clause 13. A system for optimization of energy consumption of a heating, ventilation, and air conditioning (HVAC) system in a data center, the system comprising:
   a memory;
   at least one processor coupled to the memory, wherein the at least one processor is configured to:
      receive a plurality of inputs associated with a data center at predetermined intervals, wherein the plurality of inputs comprises manipulated variable (MV) inputs and disturbance variable (DV) inputs;
      determine, using a machine learning (ML) model, a plurality of output variables of a heating, ventilation, and air conditioning (HVAC) system based on the MV inputs and the DV inputs; and
      predict MV inputs for reducing the energy consumption of the HVAC system in the data center,
      wherein to predict the at least one processor is configured to apply an optimization function on the plurality of output variables to generate the predicted MV inputs, and
      wherein the optimization function comprises plurality of parameters including Service level agreements (SLAs), total energy consumption of the HVAC system, and physics-based constraints, and wherein the optimization function defines a respective weight for a corresponding parameter of the plurality of parameters.
Clause 14. The system of clause 13,
   wherein the MV inputs at least include set points corresponding to each equipment class in the HVAC system including chiller, pumps, cooling tower, and computer room air conditioning (CRAC), and wherein the DV inputs comprises at least environmental conditions and Information Technology (IT) load,
   wherein the plurality of output variables comprises temperature and humidity condition of each zone of the data center, condenser water output, chiller output, and power consumption of equipment present in the HVAC system.
Clause 15. The system of any one of clauses 13 and 14, wherein to apply the optimization function, the at least one processor is configured to:
   predict, using the optimization function, modified MV inputs for the HVAC system for a predetermined time duration;
   determine whether the predicted MV inputs satisfies a predetermined power reduction requirement while adhering to the SLAs and the physics-based constraints;
   recommend fail-safe measures corresponding to a current status of the DV inputs, in case the predicted MV inputs fails to satisfy the predetermined power reduction requirement within the predetermined time duration, wherein recommending the fail-safe measures comprises determining optimized MV inputs based on the current status of the DV inputs and historical data set of the HVAC system; and
   recommending the predicted MV inputs as the optimized MV inputs for the HVAC system, in case the predicted MV inputs satisfies the predetermined power reduction requirement.
Clause 16. The system of clause 15, wherein the at least one processor is configured to:
   determine whether a difference between the predicted MV inputs and a previous set of MV inputs is within a predefined range of respective MV inputs; and
   in case the determined difference being outside the predefined range of respective MV inputs:
      recommend fail-safe measures including the optimized MV inputs corresponding to the current status of the DV inputs, or
      continue with the previous set of MV inputs as the optimized MV inputs corresponding to the current status of the DV inputs.
Clause 17. The system of any one of clauses 13 through 16, wherein the at least one processor is configured to:
   monitor the determined plurality of output variables of the HVAC system;
   detect a deviation in at least one output variable of the plurality of output variables at least based on corresponding deviation threshold; and
   modify a weight of parameter of the optimization function mapped to the at least one output variable based on the deviation in the at least one output variable.
Clause 18. The system of any one of clauses 13 through 17, wherein the data center is divided into plurality of zones, wherein the SLAs comprises a set of SLAs for each zone, and wherein the at least one processor is configured to:
   monitor, in real-time, sensor data of each of the plurality of zones within the data center,
   detect a deviation of the sensor data from corresponding SLAs of the at least one zone;
   apply the optimization function to predict MV inputs for the at least one zone to meet the corresponding set of SLAs, based on the detected deviation of the sensor data; and
   provide the predicted MV inputs as an optimized MV inputs for the at least one zone.
Clause 19. The system of any one of clauses 13 through 19,
   wherein the at least one processor is configured to:
   initialize the MV inputs of the HVAC system in the data center at least based on a current status of the DV inputs and historical data set of the HVAC system; and
   wherein the at least one processor is configured to:
   detect at least one outlier and/or missing variable in the MV inputs and the DV inputs; and
   apply at least imputation technique to impute variable in place of the at least one detected outlier and/or missing variable.
Clause 20. The system of any one of clauses 13 through 19, wherein the at least one processor is configured to:
   train the ML model with historical data set of the HVAC system in the data center for defined Service level agreements (SLAs), wherein the historical data set comprising historical MV inputs, the historical DV inputs, and corresponding historical output variables; and
   train the ML model further based on one or more physics-based constraints.

While various aspects and embodiments have been disclosed herein, other aspects and embodiments will be apparent to those skilled in the art. The various aspects and embodiments disclosed herein are for purposes of illustration and are not intended to be limiting, with the true scope and spirit being indicated by the following detailed description.

### Referral Numerals:

| **Referral Number** | **Description** |
|---|---|
| 100 | HVAC |
| 101 | Cooling Tower |
| 103 | One Or More Pumps |
| 105 | Chiller |
| 107 | Data Center |
| 109 | Waterside Economizer |
| 111 | Airside Economizer |
| 113 | CRAH |
| 200 | Block Diagram |
| 201 | Manipulated Variable Inputs |
| 203 | Disturbance Variable Inputs |
| 205 | Output Variables |
| 210 | ML Model |
| 301 | Manipulated Variable Inputs |
| 303 | Disturbance Variable Inputs |
| 305 | Output Variables |
| 310 | ML Model |
| 307 | Evaluation Objectives |
| 309 | Variation of MV Inputs |
| 311 | Modified MV Inputs |
| 313 | Recommended MV Inputs |
| 400 | System |
| 401 | Memory |
| 403 | At least one Processor |
| 405 | Plurality of Sensors |
| 407 | Database |
| 409 | ML Model |
| 411 | Optimization model |
| 413 | Communication Module |
| 500 | Method |
| 501 - 505 | Method steps |

## Claims

1. A method for optimization of energy consumption of a heating, ventilation, and air conditioning (HVAC) system in a data center, the method comprising:
receiving a plurality of inputs associated with a data center at predetermined intervals, wherein the plurality of inputs comprises manipulated variable (MV) inputs and disturbance variable (DV) inputs;
determining, using a machine learning (ML) model, a plurality of output variables of a heating, ventilation, and air conditioning (HVAC) system, based on the MV inputs and the DV inputs; and
predicting MV inputs for reducing the energy consumption of the HVAC system in the data center,
wherein predicting comprises applying an optimization function on the plurality of output variables to generate the predicted MV inputs, and
wherein the optimization function comprises a plurality of parameters including Service level agreements (SLAs), total energy consumption of the HVAC system, and physics-based constraints, and wherein the optimization function defines a respective weight for a corresponding parameter of the plurality of parameters.

2. The method as claimed in claim 1, wherein the MV inputs at least include set points corresponding to each equipment class in the HVAC system including chiller, pumps, cooling tower, and computer room air conditioning (CRAC), and wherein the DV inputs comprises at least environmental conditions and Information Technology (IT) load, and/or wherein the plurality of output variables comprises temperature and humidity condition of each zone of the data center, condenser water output, chiller output, and power consumption of equipment present in the HVAC system.

3. The method as claimed in any one of claims 1 or 2, wherein applying the optimization function comprises:
predicting, using the optimization function, modified MV inputs for the HVAC system for a predetermined time duration;
determining whether the predicted MV inputs satisfies a predetermined power reduction requirement while adhering to the SLAs and the physics-based constraints;
recommending fail-safe measures corresponding to a current status of the DV inputs, in case the predicted MV inputs fails to satisfy the predetermined power reduction requirement within the predetermined time duration, wherein recommending the fail-safe measures comprises determining optimized MV inputs based on the current status of the DV inputs and historical data set of the HVAC system; and
recommending the predicted MV inputs as the optimized MV inputs for the HVAC system, in case the predicted MV inputs satisfies the predetermined power reduction requirement, particularly further comprising:
determining whether a difference between the predicted MV inputs and a previous set of MV inputs is within a predefined range of respective MV inputs; and
in case the determined difference is outside the predefined range of respective MV inputs:
recommending fail-safe measures including the optimized MV inputs corresponding to the current status of the DV inputs, or
continuing with the previous set of MV inputs as the optimized MV inputs corresponding to the current status of the DV inputs.

4. The method as claimed in any one of claims 1 through 3, further comprising:
recommending the predicted MV inputs to an operator of the HVAC system or a digital control system of the HVAC system; and/or
further comprising:
monitoring the determined plurality of output variables of the HVAC system;
detecting a deviation in at least one output variable of the plurality of output variables at least based on corresponding deviation threshold; and
modifying a weight of parameter of the optimization function mapped to the at least one output variable based on the deviation in the at least one output variable.

5. The method as claimed in any one of claims 1 through 4, wherein the data center is divided into plurality of zones, wherein the SLAs comprises a set of SLAs for each zone, and wherein the method further comprises:
monitoring, in real-time, sensor data of each of the plurality of zones within the data center,
detecting a deviation of the sensor data from corresponding SLAs of the at least one zone;
applying the optimization function to predict MV inputs for the at least one zone to meet the corresponding set of SLAs, based on the detected deviation of the sensor data; and
providing the predicted MV inputs as an optimized MV inputs for the at least one zone.

6. The method as claimed in any one of claims 1 through 5, further comprising:
initializing the MV inputs of the HVAC system in the data center at least based on a current status of the DV inputs and historical data set of the HVAC system.

7. The method as claimed in any one of claims 1 through 6, further comprising:
detecting at least one outlier and/or missing variable in the MV inputs and the DV inputs; and
applying at least imputation technique to impute variable in place of the at least one detected outlier and/or missing variable.

8. The method as claimed in any one of claims 1 through 7, further comprising:
training the ML model with historical data set of the HVAC system in the data center for defined Service level agreements (SLAs), wherein the historical data set comprising historical MV inputs, the historical DV inputs, and corresponding historical output variables, particularly further comprising:
training the ML model further based on one or more physics-based constraints.

9. A system for optimization of energy consumption of a heating, ventilation, and air conditioning (HVAC) system in a data center, the system comprising:
a memory;
at least one processor coupled to the memory, wherein the at least one processor is configured to:
receive a plurality of inputs associated with a data center at predetermined intervals, wherein the plurality of inputs comprises manipulated variable (MV) inputs and disturbance variable (DV) inputs;
determine, using a machine learning (ML) model, a plurality of output variables of a heating, ventilation, and air conditioning (HVAC) system based on the MV inputs and the DV inputs; and
predict MV inputs for reducing the energy consumption of the HVAC system in the data center,
wherein to predict the at least one processor is configured to apply an optimization function on the plurality of output variables to generate the predicted MV inputs, and
wherein the optimization function comprises plurality of parameters including Service level agreements (SLAs), total energy consumption of the HVAC system, and physics-based constraints, and wherein the optimization function defines a respective weight for a corresponding parameter of the plurality of parameters.

10. The system as claimed in claim 9,
wherein the MV inputs at least include set points corresponding to each equipment class in the HVAC system including chiller, pumps, cooling tower, and computer room air conditioning (CRAC), and wherein the DV inputs comprises at least environmental conditions and Information Technology (IT) load,
wherein the plurality of output variables comprises temperature and humidity condition of each zone of the data center, condenser water output, chiller output, and power consumption of equipment present in the HVAC system.

11. The system as claimed in any one of claims 9 and 10, wherein to apply the optimization function, the at least one processor is configured to:
predict, using the optimization function, modified MV inputs for the HVAC system for a predetermined time duration;
determine whether the predicted MV inputs satisfies a predetermined power reduction requirement while adhering to the SLAs and the physics-based constraints;
recommend fail-safe measures corresponding to a current status of the DV inputs, in case the predicted MV inputs fails to satisfy the predetermined power reduction requirement within the predetermined time duration, wherein recommending the fail-safe measures comprises determining optimized MV inputs based on the current status of the DV inputs and historical data set of the HVAC system; and
recommending the predicted MV inputs as the optimized MV inputs for the HVAC system, in case the predicted MV inputs satisfies the predetermined power reduction requirement, particularly wherein the at least one processor is configured to:
determine whether a difference between the predicted MV inputs and a previous set of MV inputs is within a predefined range of respective MV inputs; and
in case the determined difference being outside the predefined range of respective MV inputs:
recommend fail-safe measures including the optimized MV inputs corresponding to the current status of the DV inputs, or
continue with the previous set of MV inputs as the optimized MV inputs corresponding to the current status of the DV inputs.

12. The system as claimed in any one of claims 9 through 11, wherein the at least one processor is configured to:
monitor the determined plurality of output variables of the HVAC system;
detect a deviation in at least one output variable of the plurality of output variables at least based on corresponding deviation threshold; and
modify a weight of parameter of the optimization function mapped to the at least one output variable based on the deviation in the at least one output variable.

13. The system as claimed in any one of claims 9 through 12, wherein the data center is divided into plurality of zones, wherein the SLAs comprises a set of SLAs for each zone, and wherein the at least one processor is configured to:
monitor, in real-time, sensor data of each of the plurality of zones within the data center,
detect a deviation of the sensor data from corresponding SLAs of the at least one zone;
apply the optimization function to predict MV inputs for the at least one zone to meet the corresponding set of SLAs, based on the detected deviation of the sensor data; and
provide the predicted MV inputs as an optimized MV inputs for the at least one zone.

14. The system as claimed in any one of claims 9 through 13,
wherein the at least one processor is configured to:
initialize the MV inputs of the HVAC system in the data center at least based on a current status of the DV inputs and historical data set of the HVAC system; and
wherein the at least one processor is configured to:
detect at least one outlier and/or missing variable in the MV inputs and the DV inputs; and
apply at least imputation technique to impute variable in place of the at least one detected outlier and/or missing variable.

15. The system as claimed in any one of claims 9 through 14, wherein the at least one processor is configured to:
train the ML model with historical data set of the HVAC system in the data center for defined Service level agreements (SLAs), wherein the historical data set comprising historical MV inputs, the historical DV inputs, and corresponding historical output variables; and
train the ML model further based on one or more physics-based constraints.
